# EUROPEAN PATENT APPLICATION

(11) **EP 2 863 186 A1**
(43) Date of publication of application: **22.04.2015**
(21) Application number: 13885455.9
(22) Date of filing: 23.08.2013
(51) Int. Cl.: G01D 21/00

(54) **HUMAN-MACHINE INTEGRATED QUALITY INSPECTION SYSTEM AND METHOD IN DIGITAL PRODUCT INSPECTION**

(30) Priority: 21.08.2013 CN 201310368147
(71) Applicant: Guangdong Electronics Industry Institute Ltd., Dongguan, Guangdong 523808 (CN)
(72) Inventor: YUAN, Zimu, DongGuan Guangdong 523808 (CN); YUAN, Ningxin, DongGuan Guangdong 523808 (CN); XU, Zhiwei, DongGuan Guangdong 523808 (CN); JI, Tongkai, DongGuan Guangdong 523808 (CN)
(74) Representative: Hocking, Adrian Niall
(86) International application number: PCT/CN2013/082235
(87) International publication number: WO 2015/024268

(57) **Abstract**

A testing method of a human-computer combination quality testing system includes steps of: after manufacture, importing relevant CAD models, submitting the CAD models to a digital testing part for examination; if a product is determined to be defective, returning the product for retreatment; if the product is determined to be meet requirements, submitting the product to a manual testing part for examination by relevant inspectors; if the product is determined to be meet requirements by the inspectors, the product leaves the factory as a qualified product; if the product is determined to be defective by the inspectors, returning the product for retreatment; then changing the relevant rule with a rule corrector of a system improving part according to a misjudging condition of the digital testing part; describing a corrected rule corrected by the developer via a rule descriptor; then applying the corrected rule to a system by a rule parser. The present invention combines advantages of digital testing and personal experience, and is applicable to digital product testing.

## Description

### Field of Invention

The present invention relates to a technical field of product quality testing, and more particularly to a human-computer combination quality testing system for digital product testing which combines personal experience and instrument examination, and a testing method thereof.

### Description of Related Arts

Until digital product quality testing is popularized in an industry, product quality control is handled by personnel experienced in producing the product or personnel who has learnt the relevant testing knowledge sufficiently. Usually, the personnel will judge products by their appearances, texture, etc., which is based on personal perception, for identifying defective products. However, human is not a machine, and the personnel cannot keep a constant focus during product testing and defective products may escape detection due to this lack of concentration. Furthermore, not everyone has a complete knowledge of the product, and incomplete knowledge may also cause defective products to escape detection. If too many parts of the product need to be tested or testing process is too long, it will take a certain amount of time for the personnel to examine each product, which will lower the efficiency of production and product yields. In some companies or factories in certain industries, product testing is in a workflow form, and each personnel is only responsible for a small part of product quality testing. However, problems of lack of concentration and low production efficiency still exist.

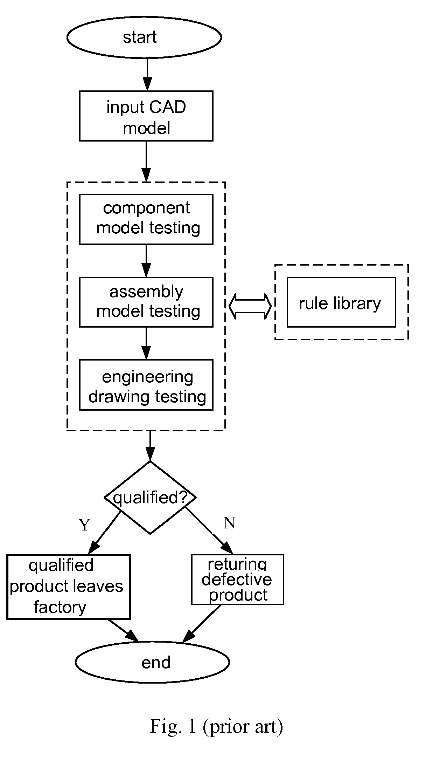

Some industries introduce digital product quality testing systems (as illustrated in Fig. 1). By pre-inputting prior knowledge to a rule library of the system, a product is examined via component model testing, fit model testing and engineering drawing testing to determine whether it meets requirements. Digital product quality testing system is able to improve the efficiency of product testing and save a lot of time compared with manual product testing, which increases production efficiency and yield. Although the digital product quality testing system improves the testing efficiency, the problem of incomplete knowledge still exists. Developers of the digital system often do not have specific product knowledge. Therefore, detailed description by specialists in the relevant field is necessary for the system development. However, both the developers and the specialists are not able to completely and precisely input relevant testing logic rules into the system only through communication during development, and may even input wrong testing logic rules because of misunderstanding. The risk of an incomplete system or a system with errors is even greater when the system is complex or variable.

As long as the products are tested only by personal experience or digital testing system, problems of incomplete knowledge, misunderstanding and efficiency exist. By combining advantages of both sides and learning from each other, product quality testing processes of products is improved.

### Summary of the Present Invention

A first object of the present invention is to provide a human-computer combination quality testing system for solving problems such as neglect and misjudgment, which combines and takes advantages of digital testing and manual testing for improving testing processes and a detection rate of unqualified products.

A second object of the present invention is to provide a testing method of a human-computer combination quality testing system for solving problems such as neglect and misjudgment, which combines and takes advantages of digital testing and manual testing for improving testing processes and a detection rate of unqualified products.

Accordingly, in order to accomplish the first object, the present invention provides:
a human-computer combination quality testing system for digital product testing and a testing method thereof, comprising: a digital testing part, a manual testing part, and a system improvement part;
wherein the digital testing part comprises: a component model testing, an assembly model testing and an engineering drawing testing;
the manual testing part is an appraising of products from their parts, assemblies to end products by an inspector, for separating defective products from non-defective products;
the system improvement part comprises: a rule descriptor, a rule parser, and a rule corrector;
wherein the rule descriptor comprises: rule bindings, trigger conditions, violation types and disposal types; the rule bindings comprise binding of at least one of the component model testing, the assembly model testing and the engineering drawing testing; the trigger conditions comprise setting of trigger conditions set according to standards of a point-line model, surfaces, boundaries and textures of a component model, setting of trigger conditions according to restriction settings of an assembly relationship and an assembly sequence of an assembly model, and setting of trigger conditions according to a size and view correlations between an engineering drawing and a model; the violation types are described using a quantified percentage form; the disposal types comprise: adjustment, modification and a re-execution, and the disposal types being correlated to the violation types;
the rule parser parses semantemes described in a rule, the parsed semantemes comprise corresponding relationships between symbols and basic elements which includes the point-line model, the surfaces and the textures; and restriction relationships of proportions, associations, contents and sequences; and parsing of movements comprising hitting, squeezing and measuring;
the rule corrector provides an interface for editing the rule, so as to expand, modify, delete and query the rule.

The rule descriptor sets the trigger conditions according to the standards of points, lines, the surfaces, the boundaries and the textures of the component model; sets the trigger conditions according to the assembly relationship and the assembly sequence of the assembly model, and sets trigger conditions according to the size and view correlations between the engineering drawing and the model; if the conditions are abnormal, a rule is triggered for warming about detection of an irregularity;
wherein the standards of the component model are described by a chain table structure; the points, the lines and the boundaries are described by a 1-dimensional chain table structure, each element thereof is directed to a next element by a pointer and is described as Element = (x,y,z) for describing a 3-dimensional point position; the surfaces and the textures are described by a 2-dimensional chain table structure, each element thereof is directed to an up element, a down element, a left element and a right element by four pointers and is described as Element = (x,y,z, d), wherein x, y and z describe a 3-dimensional point position, and d describes the texture at (x, y, z); dependencies of the assembly model are described by collectively by sets, wherein *S*₁ ⊆ *S*₂ illustrates that parts represented by *S*₁ are subordinate to parts represented by *S*₂; *S*₁∩*S*₂ illustrates that the parts represented by *S*₁ and the parts represented by *S*₂ should be assembled together for forming a new part; the assembly sequence of the assembly model is described by an order set, wherein < *S*₁,*S*₂, ...,*S*ₙ > illustrates that *S*₁ is assembled first, then *S*₂, and finally *Sₙ*; the size correlation between the engineering drawing and the model is described by a scale; the view correlation between the engineering drawing and the model is described as G = (V, E), wherein V is an apex set of said view, E is a vector side set of the view; v₁ and v₂ respectively represent two views, e₁₂ describes a correlation between v₁ and v₂; standard settings, assembly restrictions and correlation rules defined above form the trigger conditions, the trigger conditions are marked as C.

A rule of the rule bindings of the rule descriptor is described as < Logic(*C*₁,*C*₂, ..., *C*ₘ), Component/Fit/Drawing >, wherein Logic(*C*₁, *C*_{2,} ..., *C*ₘ) is a logic system comprising a series of trigger rules, which is corresponding to Component/Fit/Drawing; the logic system comprises ∧, V and - basic operations, wherein *C*₁∧*C*₂ requires that both *C*₁ and *C*₂ are true, *C*₁ V *C*₂ requires that either *C*₁or *C*₂ is true, and *̅C̅*̅₁̅ requires that *C*₁ is not true; the rule is marked as R;
wherein said violation types of said rule descriptor use said quantified percentage form for describing a severity of rule violation;, each rule corresponds to one violation type, which is marked as < R, Degree, Reply >; said degree of violation severity are adjustable according to requirements; for example, Degree of 1%∼10% represents a slight irregularity with slight inconformity and defects, Degree of 11%∼30% represents a medium degree of irregularity; Degree of above 30% represents a serious irregularity;
wherein said disposal types of said rule descriptor comprise: said adjustment, said modification and said re-execution, which correlate with the degree of violation severity and correspond to one rule and one violation type; if there is a slight irregularity then there is a need for adjustment, if there is a medium degree of irregularity then there is a need for modification, and if there is a serious irregularity then there is a need for re-execution.

The component model testing of the digital testing part determines whether elements comprising the points, the lines, the surfaces, the boundaries and the textures meet requirements, wherein the points, the lines and the boundaries are described by the 1-dimensional chain table, the surfaces and the textures are described by the 2-dimensional chain table;
wherein the assembly model testing of the digital testing part determines whether the components are assembled according to the rules, and examines the restrictions comprising the assembly relationship and the assembly sequence; the relationship is represented by combined operations; the assembly sequence is described by the order set;
wherein the engineering drawing testing of the digital testing part detects the size and view correlations between the engineering drawing and the model, the size correlation between the engineering drawing and the model is described by the scale; and the view correlation between the engineering drawing and the model is described as G = (V, E), wherein V represents a view set, and E represents a relationship set of the view correlation.

Accordingly, in order to accomplish the first object, the present invention provides:
a product quality testing method using a human-computer combination quality testing system, comprising steps of: after manufacture, importing relevant CAD models, submitting the CAD models to a digital testing part for examination; examining in sequence the component model testing, assembly model testing and engineering drawing testing for determining whether a relevant rule is violated; if a product is determined to be defective after being tested by said three testing, returning the product for processing including adjustment, modification or re-execution; if the product is determined to meet requirements after being tested by said three testing, submitting the product to a manual testing part for being examined by relevant inspectors; if the product is determined to meet requirements by the inspectors, the product leaves the factory as a qualified product; if the product is determined to be defective by the inspectors, returning the product for processing including adjustment, modification or re-execution, and submitting an explanation of the situation to a developer; the developer then adds, changes or deletes the relevant rule via a rule corrector of a system improving part according to a misjudging condition of the digital testing part; describing a corrected rule corrected by the developer via a rule descriptor; then applying the corrected rule to a system by a rule parser for avoiding misjudging of the same condition.

Therefore, with the system improving part, the human-computer combination quality testing system does not requires a completed rule library of a system rule library at the beginning. The rule library keeps being improved with growth of time and experience, or with changes of system testing requirements, for completing the system. In the meantime, an improving process and a manufacturing process are able to be provided at the same time, in such a manner that there is no need to stop producing.

### Brief Description of the Drawings

Referring to the drawings, the present invention is further illustrated.
Fig. 1 is a diagrammatic representation of a conventional digital product quality testing system.
Fig. 2 is a simplified diagrammatic representation of a human-computer combination quality testing system according to the present invention.
Fig. 3 is a simplified diagrammatic representation of a point-line model according to the present invention.
Fig. 4 is a simplified diagrammatic representation of a surface model according to the present invention.
Fig. 5 is a simplified diagrammatic representation of a view correlation according to the present invention.

### Detailed Description of the Preferred Embodiment

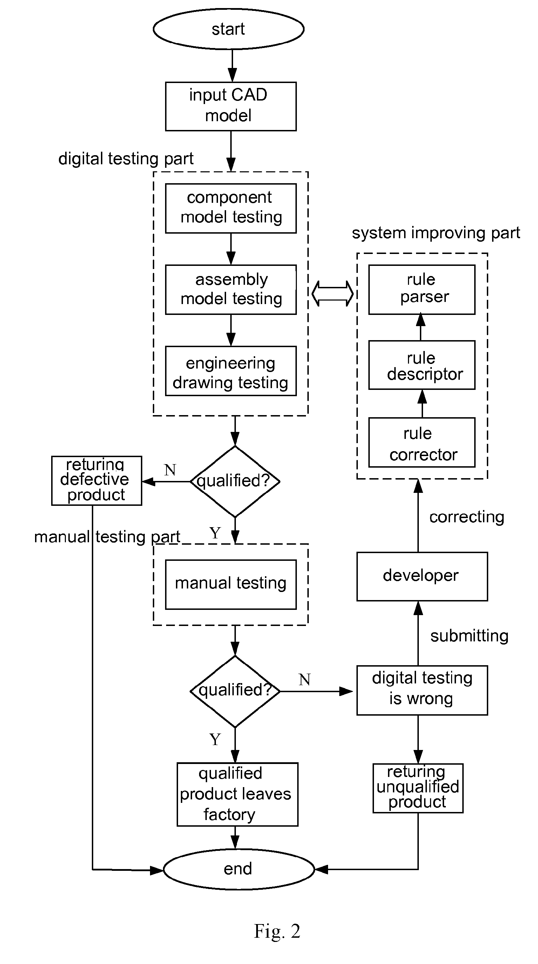

Referring to Fig. 2, a human-computer combination quality testing system according to the present invention comprises: a digital testing part, a manual testing part, and a system improvement part.

The digital testing part may be an original system without human-computer combination, which does not need to be changed. The digital testing part comprises: a component model testing, an assembly model testing and an engineering drawing testing. The component model testing determines whether elements comprising the point-line models, surfaces, boundaries and textures meet requirement. The assembly model testing determines whether components involved in assembling are assembled correctly, and examines restrictions of an assembly relationship and an assembly sequence, etc. The engineering drawing testing tests size and view correlations between an engineering drawing and a model.

The manual testing part is appraising of products from their components or parts and assembly to end products by an inspector with component manufacturing and assembling experience, for separating defective products from non-defective products.

The system improvement part comprises: a rule descriptor, a rule parser, and a rule corrector.

The rule descriptor is a four-element group (Condition, Binding, Type, Reply), comprising: trigger conditions Condition, rule bindings Binding, violation types Degree and disposal types Reply.

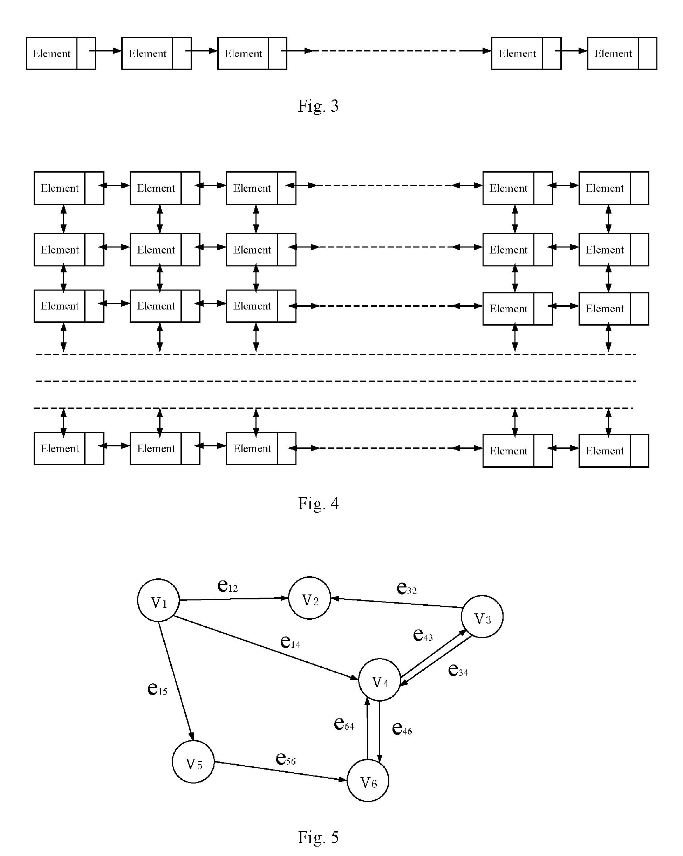

The rule descriptor comprises the trigger conditions Condition. The rule descriptor sets the trigger conditions according to the standard settings of points, lines, the surfaces, the boundaries and the textures of a component model; sets the trigger conditions according to the restriction settings of the assembly relationship and the assembly sequence, etc., of the assembly model; and sets trigger conditions according to the size and view correlations between the engineering drawing and the model. If the conditions are abnormal, a rule is triggered for warming about an irregularity detected. The standards of the component model are described by a chain table structure; the points, the lines and the boundaries are described by a 1-dimensional chain table structure, each element thereof is directed to a next element by a pointer as shown in Fig. 3, and is described as Element = (x,y, z) for describing a 3-dimensional point position. The surfaces and the textures are described by a 2-dimensional chain table structure, each element thereof is directed to an up element, a down element, a left element and a right element by four pointers as shown in Fig. 4, and is described as Element = (x, y, z, d), wherein x, y and z describe a 3-dimensional point position, d describes the texture at the point(x, y, z). Dependencies of the assembly model are described collectively by sets, wherein *S*₁ *⊆ S*₂ illustrates that parts represented by *S*₁ are subordinate to parts represented by *S*₂; *S*1∩*S*₂ illustrates that the parts represented by *S*₁ and the parts represented by *S*₂ should be assembled together for forming a new part. The assembly sequence of the assembly model is described by an order set, wherein <*S*₁,*S*_{2,}...,*Sₙ* > illustrates that *S*₁ is assembled first, then *S*₂, and finally *Sₙ*. The size correlation between the engineering drawing and the model is described by a scale. The view correlation between the engineering drawing and the model is described as G = (V,E), wherein V is an apex set of said view, E is a vector side set of the view. Referring to Fig. 5, v₁ and v₂ respectively represent two views, e₁₂ describes a correlation between v₁ and v₂; standard settings, assembly restrictions and correlation rules defined above form the trigger conditions, the trigger conditions are marked as C.

The rule descriptor comprises the rule bindings Binding. For each unit of the digital testing part, such as the component model testing ('Component' for short), the assembly model testing ('Fit' for short) and the engineering drawing testing ('Drawing' for short), requirements for quality testing are different, and corresponding rules are also different. Different units of the digital testing part are bounded with different rules. The rule is described as < Logic(*C*₁,*C*_{2,}...,*Cₘ*)*,* Component/Fit/Drawing>, wherein Logic(*C*₁, C*₂,...,Cₘ*) is a logic system comprising a series of trigger rules, which is corresponding to Component/Fit/Drawing, etc., units; the logic system comprises A , V and - basic operations, wherein *C*₁∧*C*₂ requires that both *C*₁ and *C*₂ are true, *C*₁ V *C*₂ requires that either *C*₁ or *C*₂ is true, and *̅C̅*̅₁̅ requires that *C*₁ is not true; the rule is marked as R.

The rule descriptor comprises the violation types Degree, wherein the violation types use the quantified percentage form for describing a severity of rule violation; each rule corresponds to one violation type, which is marked as < R, Degree, Reply >; the degree of violation severity are adjustable according to requirements; for example, Degree of 1%∼10% represents a slight irregularity with slight inconformity and defects, Degree of 11%∼30% represents a medium degree of irregularity; Degree of above 30% represents a serious irregularity.

The rule descriptor comprises the disposal types Reply, wherein the disposal types comprise: adjustment (Adjust for short), modification (Modify for short) and the re-execution (Redo for short), the disposal types being correlated to the violation types, and each rule corresponds to one violation type, are described as < R, Degree, Reply >. If there is a slightly irregularity then there is a need for adjustment, if there is a medium degree of irregularity then there is a need for modification, and if there is a serious irregularity then there is a need for re-execution.

The rule parser parses semantemes described in the rule, the parsed semantemes comprise corresponding relationships between symbols and basic elements which includes the point-line model, the surfaces and the textures; and restriction relationships of proportions, associations, contents and sequences; and parsing of movements comprising hitting, squeezing and measuring.

The rule corrector provides an interface for editing the rule. For the rules which are determined as wrong, a deleting operation may be provided, provided as Deplete(< R, Degree, Reply >). For incomplete rule libraries, an adding operation may be provided, provided as Add( < R, Degree, Reply >). For the rules with problems, a modifying operation may be provided, provided as Modify(< R, Degree, Reply >). For all the rules in the rule library, a querying operation may be provided, provided as Query(< R, Degree, Reply >).

Referring to Fig. 2, a testing method of a human-computer combination quality testing system is provided, comprising steps of: after manufacture, importing relevant CAD models, submitting the CAD models to a digital testing part for examination; examining the component model testing, assembly model testing and engineering drawing testing for determining whether a relevant rule is violated; if a product is determined to be defective after being tested by said three testing, returning the product for processing including adjustment, modification or re-execution; if the product is determined to meet requirements after being tested by said three testing, submitting the product to a manual testing part for being examined by relevant inspectors; if the product is determined to meet requirements by the inspectors, the product leaves the factory as a qualified product; if the product is determined to be defective by the inspectors, which means that a result of the digital testing part is wrong, returning the product for processing including adjustment, modification or re-execution, and submitting an explanation of the situation to a developer; the developer then adds, changes or deletes the relevant rule via a rule corrector of a system improving part according to a misjudging condition of the digital testing part; describing a corrected rule corrected by the developer via a rule descriptor; then applying the corrected rule to a system by a rule parser for avoiding misjudging of the same condition.

## Claims

1. A human-computer combination quality testing system for digital product testing and a testing method thereof, comprising: a digital testing part, a manual testing part, and a system improvement part;
wherein said digital testing part comprises: a component model testing, an assembly model testing and an engineering drawing testing;
said manual testing part is an appraising of products from their parts, assemblies to end products by an inspector for separating defective products from non-defective products;
said system improvement part comprises: a rule descriptor, a rule parser, and a rule corrector;
wherein said rule descriptor comprises: rule bindings, trigger conditions, violation types and disposal types;
said rule bindings comprise binding of at least one of the component model testing, the assembly model testing and the engineering drawing testing;
said trigger conditions comprise setting of trigger conditions according to standards of a point-line model, surfaces, boundaries and textures of a component model, setting of trigger conditions according to restriction settings of an assembly relationship and an assembly sequence of an assembly model, and setting of trigger conditions according to a size correlation and a view correlation between an engineering drawing and a model;
the violation types are described using a quantified percentage form;
the disposal types comprise: adjustment, modification and a re-execution, and the disposal types being correlated to the violation types;
said rule parser parses semantemes described in a rule, said parsed semantemes comprise corresponding relationships between symbols and basic elements which includes the point-line model, the surfaces and the textures; and restriction relationships of proportions, associations, contents and sequences; and parsing of movements comprising hitting, squeezing and measuring;
said rule corrector provides an interface for editing the rule, so as to expand, modify, delete and query the rule.

2. A human-computer combination quality testing system as claimed in claim 1, wherein said rule descriptor sets said trigger conditions according to said standards of points, lines, said surfaces, said boundaries and said texture of said component model, sets said trigger conditions according to said assembly relationship and said assembly sequence of said assembly model, and sets trigger conditions according to said size and view correlations between said engineering drawing and said model; if said conditions are abnormal, a rule is triggered for warming about detection of an irregularity;
wherein said standards of said component model are described by a chain table structure; said points, said lines and said boundaries are described by a 1-dimensional chain table structure, each element thereof is directed to a next element by a pointer and is described as Element = (x,y,z) for describing a 3-dimensional point position; said surface and said textures are described by a 2-dimensional chain table structure, each element thereof is directed to an up element, a down element, a left element and a right element by four pointers and is described as Element = (x,y, z, d), wherein x, y and z describe a 3-dimensional point position and d describes said texture at (x, y, z); dependencies of said assembly model are described collectively by sets, wherein *S*₁ *⊆ S*₂ illustrates that parts represented by *S*₁ are subordinate to parts represented by *S*₂; *S*₁∩*S*₂ illustrates that said parts represented by *S*₁ and said parts represented by *S*₂ should be assembled together for forming a new part; said assembly sequence of said assembly model is described by an order set, wherein < *S*₁,*S*_{2,}...,*Sₙ* > illustrates that *S*₁ is assembled first, then *S*₂, and finally *Sₙ*; said size correlation between said engineering drawing and said model is described by a scale; said view correlation between said engineering drawing and said model is described as G = (V,E), wherein V is an apex set of said view, E is a vector side set of said view; v₁ and v₂ respectively represent two views, e₁₂ describes a correlation between v₁ and v₂ ; standard settings, assembly restrictions and correlation rules defined above form said trigger conditions, said trigger conditions are marked as C.

3. A human-computer combination quality testing system as claimed in claim 1 or claim 2, wherein a rule of said rule bindings of said rule descriptor is described as < Logic(*C*₁,*C*₂, ..., *Cₘ*), Component/Fit/Drawing >, wherein Logic(*C*₁, *C*₂,..., *Cₘ*) is a logic system comprising a series of trigger rules, which is corresponding to Component/Fit/Drawing; said logic system comprises ∧ , V and - basic operations, wherein C*₁*∧*C*₂ requires that both *C*₁ and *C*₂ are true, *C*₁ *V C*₂ requires that either *C*₁ or *C*₂ is true, and *̅C̅*̅₁̅ requires that *C*₁ is not true; said rule is marked as R;
wherein said violation types of said rule descriptor use said quantified percentage form for describing a severity of rule violation;, each rule corresponds to one violation type, which is marked as < R, Degree, Reply >; said degree of violation severity are adjustable according to requirements; for example, Degree of 1%∼10% represents a slight irregularity with slight inconformity and defects, Degree of 11%∼30% represents a medium degree of irregularity; Degree of above 30% represents a serious irregularity;
wherein said disposal types of said rule descriptor comprise: said adjustment, said modification and said re-execution, which correlate with the degree of violation severity and correspond to one rule and one violation type; if there is a slight irregularity then there is a need for adjustment, if there is a medium degree of irregularity then there is a need for modification, and if there is a serious irregularity then there is a need for re-execution.

4. A human-computer combination quality testing system as claimed in claim 1 or claim 2, wherein said component model testing of said digital testing part determines whether elements comprising said points, said lines, said surfaces, said boundaries and said textures meet requirement, wherein said points, said lines and said boundaries are described by said 1-dimensional chain table, said surfaces and said textures are described by said 2-dimensional chain table;
wherein said assembly model testing of said digital testing part determines whether said components are assembled according to the rules, and examines said restrictions comprising said assembly relationship and said assembly sequence; said relationship is represented by combined operations; said assembly sequence is described by said order set;
wherein said engineering drawing testing of said digital testing part detects said size and view correlations between said engineering drawing and said model, said size correlation between said engineering drawing and said model is described by said scale; and said view correlation between said engineering drawing and said model is described as G = (V,E), wherein V represents a view set, and E represents a relationship set of said view correlation.

5. A human-computer combination quality testing system as claimed in claim 3, wherein said component model testing of said digital testing part determines whether elements comprising said points, said lines, said surfaces, said boundaries and said textures meet requirements, wherein said points, said lines and said boundaries are described by said 1-dimensional chain table, said surfaces and said textures are described by said 2-dimensional chain table;
wherein said assembly model testing of said digital testing part determines whether said components are assembled according to the rules, and examines said restrictions comprising said assembly relationship and said assembly sequence; said relationship is represented by combined operations; said assembly sequence is described by said order set;
wherein said engineering drawing testing of said digital testing part detects said size and view correlations between said engineering drawing and said model, said size correlation between said engineering drawing and said model is described by said scale; and said view correlation between said engineering drawing and said model is described as G = (V,E), wherein V represents a view set, and E represents a relationship set of said view correlation.

6. A product quality testing method using the human-computer combination quality testing system as claimed in claim 1, comprising steps of: after manufacture, importing relevant CAD models, submitting the CAD models to a digital testing part for examination; examining in sequence the component model testing, assembly model testing and engineering drawing testing for determining whether a relevant rule is violated; if a product is determined to be defective after being tested by said three testing, returning the product for processing including adjustment, modification or re-execution; if the product is determined to meet requirements after being tested by said three testing, submitting the product to a manual testing part for being examined by relevant inspectors; if the product is determined to meet requirements by the inspectors, the product leaves the factory as a qualified product; if the product is determined to be defective by the inspectors, returning the product for processing including adjustment, modification or re-execution, and submitting an explanation of the situation to a developer; the developer then adds, changes or deletes the relevant rule via a rule corrector of a system improving part according to a misjudging condition of the digital testing part; describing a corrected rule corrected by the developer via a rule descriptor; then applying the corrected rule to a system by a rule parser for avoiding misjudging of the same condition.
